# EUROPEAN PATENT SPECIFICATION

(11) **EP 0 280 292 B1**
(45) Date of publication and mention of the grant of the patent: **26.07.1995**
(21) Application number: 88102805.4
(22) Date of filing: 25.02.1988
(51) Int. Cl.: H01L 39/24, C04B 35/00

(54) **Method of manufacturing a layer of oxide superconductive material**
Verfahren zur Herstellung einer Schicht aus supraleitendem Oxidmaterial
Procédé de la fabrication d'une couche en matériau d'oxyde supraconducteur

(30) Priority: 26.02.1987 JP 44264/87; 26.02.1987 JP 44265/87; 05.03.1987 JP 51140/87; 27.03.1987 JP 75427/87; 14.04.1987 JP 91723/87; 16.05.1987 JP 119792/87; 20.08.1987 JP 207743/87
(43) Date of publication of application: 31.08.1988
(73) Proprietor: SUMITOMO ELECTRIC INDUSTRIES LIMITED, Osaka-shi, Osaka 541 (JP)
(72) Inventor: Inazawa, Shinji, Osaka (JP); Nakai, Yoshihiro, Osaka (JP); Sawada, Kazuo, Osaka (JP); Hayashi, Kazuhiko, Osaka (JP); Takahashi, Kenichi, Osaka (JP); Miyazaki, Kenji, Osaka (JP); Yoshida, Noriyuki, Osaka (JP); Takano, Satoshi, Osaka (JP); Hayashi, Noriki, Osaka (JP)
(74) Representative: KUHNEN, WACKER & PARTNER

(56) References cited:
- EP-A- 0 160 456
- US-A- 4 419 125
- US-A- 4 485 094
- Z. Phys. B, Condensed Matter 64, (1986), pages 189-193, J. G. Bednorz and K. A. Müller
- CHEMICAL ABSTRACTS vol. 100, no. 20, 14 May 1984, page 572, abstract no. 165516u, Columbus, Ohio, US & JP-A-5827389
- JAPANESE JOURNAL OF APPLIED PHYSICS vol. 27, no. 1, January 1988, pages L53, L54; S. SHIBATA et al.:"Superconducting Oxides by the Sol-Gel Method Using Alkoxides"
- VIDE, vol. 40, no. 227, May/June 1985, pages 277-280, Paris, FR; C. GUIZARD et al.: "Utilisation des procédés "sol-gel" pour l'obtention de couches minces céramiques"

## Description

### BACKGROUND OF THE INVENTION

### Field of the Invention

The present invention relates to a method of forming superconductive layer of Y-Ba-Cu-O on the surface of a substrate of polycrystal yttria stabilized zirconia, characterized in preparing yttrium-3-ethyl-3-pentoxide and barium-3-ethyl-3-pentoxide and mixing them with copper-2-ethyl-hexanoate to provide a raw material compound, solving said raw material compound in a mixture of 1 part (vol) t-heptanol and 5 parts (vol) p-xylene adding water to said solution and causing a hydrolysis and dehydration/condensation reaction coating said solution on a substrate of polycrystal yttria stabilized zirconia; and firing the coated film formed on said substrate.

### Description of the Prior Art

Ceramics oxide materials have recently been watched as superconductive materials having higher critical temperatures. Such ceramics oxide superconductive materials are generally prepared by compression-molding raw materials of ceramics powder by press working and thereafter sintering the same. Study has been made to process such superconductive materials into elongated bodies, to utilize the same as electric transmission media etc.

Elongated bodies having the aforementioned superconductive materials are manufactured by:
(a) a method of making growth from a vapor phase, such as CVD (chemical vapor deposition), PVD (physical vapor deposition) etc. (vapor phase method); and
(b) a method of sintering bulk-mixed raw material particles (powder sintering method).

However, an oxide superconductive material generally has a high melting point and hence, within the aforementioned methods, the vapor phase method (a) requires specific equipments such as a plasma generator and an apparatus for heating raw materials, and film formation is performed under a high-temperature atmosphere. According to the vapor phase method, further, high cleanliness is required on the surface of a base material to be provided with a thin film, and hence the surface must be polished in a high degree as pretreatment.

On the other hand, the final configuration of an oxide superconductive material obtained by the powder sintering method (b) depends on the configuration of a molding jig in bulk mixing of raw material particles, and hence it has been difficult to obtain an elongated body, for example. Further, the oxide superconductive material obtained by this method is heterogenous in composition because of residual unreacted parts of powder particles.

Further, an elongated body of a generally studied superconductive material has no flexibility, and hence disconnection may be caused when the same is wound up by a reel having a small radius of curvature etc. Thus, it has been impossible to obtain a practical elongated body by a conventional method. Further, manufacturing steps have been complicated.

US-4 4885 094 discloses a method of making a continous mixed oxide thin film from an oxide source of one of the metals in the mixed oxide, a chelate source of a second metal in the mixed oxide, sufficient alcohol to solubilize sources of all metals instead of mixed oxide and about 1 to about 2 moles of water per mole of mixed oxide. The mixed oxides have the general formular ABO₃, where A is bivalent and B ist tetravalent.

### SUMMARY OF THE INVENTION

An object of the present invention is to provide a method of forming a thin film of an oxide superconductive material showing a high critical temperature, which can be manufactured under a lower temperature to easily obtain a thin film,. which is homogenous in composition with no unreacted parts on the surface of a base material.

In a method of forming a superconductive layer of Y-Ba-Cu-O- on the surface of a substrate of polycrystal yttria stabilized zirconia, yttrium-3-ethyl-3-pentoxide and barium-3-ethyl-3-pentoxide are prepared and mixed with copper-2-ethyl-hexanoate to provide a raw material compound, said raw material compound is dissolved in a mixture of 1 part (vol) t-heptanol and 5 part (vol) p-xylene, water is added to said solution which causes a hydrolysis and dehydration/ condensation reaction, said solution is coated on a substrate of polycrystal yttria stabilized zirconia; and the coated film formed on said substrate is fired.

In addition to the aforementioned conventional vapor phase method, there is a method of obtaining oxide ceramics powder from a liquid phase as a method of obtaining oxide ceramics. Such a method includes a method of obtaining oxide ceramics by hydrolyzing starting materials of compounds of elements for forming the target oxide ceramics, i.e., a method employing the sol-gel method. According to this method, viscosity is increased with progress of hydrolysis, and hence the oxide ceramics can be spun into fiber or applied onto a base material similarly to the case of organic high polymer, by selecting appropriate hydrolytic stages. Thus, it is recognized that a thin film of an oxide superconductive material can be obtained by application of the sol-gel method. The present invention is based on such view of the inventors.

The mixture of alkoxides, carboxylates and/or acetylacetonatos prepared in the aforementioned manner is dissolved in an organic solvent, and water is added to the solution to hydrolyze the same. Further, dehydration/condensation reaction is caused if necessary. Thus, a sol or gel solution is obtained. Then the solution is shaped into fiber by spinning or the like, or applied to the surface of a base material to form a film. At this time, it is preferable to adjust viscosity which is increased with progress of hydrolysis. The fibrous substance thus obtained or the film formed on the surface of the base material is heated, thereby to obtain a fine wire or a thin film of an oxide superconductive material containing respective elements contained in the compounds, which are starting materials.

Solutions containing the alkoxides, carboxylates or acetylacetonatos of the respective elements may be separately hydrolyzed to be thereafter mixed with each other. Alternatively, such solutions may be mixed with each other to be thereafter hydrolyzed, as hereinabove described.

In a step of heating a mixture of the solutions, the mixed solution may be gradually dried to form a cake, which in turn is heated to a temperature of about 700 to 800°C to obtain a bulky oxide superconductive material. Or, such a heating step may be performed under a state decompressed from the atmospheric pressure, and under such decompression, heating is performed at a temperature lower than the aforementioned preferable temperature under the atmospheric pressure, i.e., about 300 to 800°C. Or, the heating step may be performed by first heating the solution in the atmosphere and thereafter re-heating the same in an oxygen atmosphere, thereby to increase the critical temperature of the oxide superconductive material thus obtained.

Thus, the method according to the present invention, including the step of mixing the solutions containing raw materials, can be performed under a low temperature of less than 1000°C, as compared with reaction for heating/melting the raw materials to/at a temperature exceeding 1000°C. Further, since liquids are mixed with each other to improve dispersibility of the raw materials, a homogenous oxide superconductive material can be obtained as a final product. In addition, spinning or application can be performed by adjusting viscosity of the solution after hydrolysis, whereby an elongated body, for example, can be obtained.

According to the sol-gel method, a solution is converted from a sol into a gel with progress of dehydration/condensation reaction. The solidified gel is converted into a sol by heating, and the sol is converted into a gel by cooling.

Through such characteristic, a substance once gelating is heated for solation, and the solating substance is then elongated by providing a hole in a lower portion of a heating vessel and drawing out the solating substance through the hole. Then, the elongated sol is cooled to be converted into a gel. When the substance heated to solate is elongated, the elongated body can be easily varied in sectional configuration to be in the form of a fine wire, a tape etc. including a deformed configuration by devising the sectional configuration of a portion for passing the solating substance. Further, the elongated body can be varied in sectional area in a wide range by arbitrarily selecting the size of the sectional area of the portion for passing the solating substance.

The mixed solution may be applied to at least a part of the surface of a base material, and application to the entire surface is not required so far as a superconductive layer continuous in the longitudinal direction can be formed. It is preferable to perform such application of the solution to the surface of the base material and heating/firing at least twice so that no cracking is caused in the superconductive layer after firing.

The superconductive layer obtained by heating/firing in the present invention is excellent in adhesion to the base material and has high rupture strength, while no cracking or disconnection is caused when the same is bent in prescribed curvature.

The oxide superconductive material obtained by the present invention is oxide ceramics supposed to have layer perovskite structure, such as Y-Ba-Cu-O oxide.

Such elements may be partially replaced by other elements. Y₁Ba₂Cu₃Oₓ (x = 6.3 to 6.9) is well known as composition showing superconductivity at the temperature of liquid nitrogen.

The base material employed in the present invention is prepared by YSZ (yttrium stabilized zirconia), etc. Within these, known are those containing several % of oxide yttrium for improving flexibility.

The base material is in the form of a tape or a round wire, for example. When a tape-like base material of ceramics is employed in view of strength and flexibility, thickness thereof is preferably within a range of 30 to 500 »m, while the diameter is preferably within a range of 30 to 500 »m in the case of a base material being in the form of a round wire.

A flexible tape-like base material of ceramics is prepared by a zirconia tape having characteristics such as surface roughness Ra of about 0.3 »m, Rₘₐₓ of about 2 »m and rupture strength at 25°C of 11000 kg/cm² or an alumina tape having characteristics such as surface roughness Ra of about 0.3 »m, Rₘₐₓ of about 3 »m and rupture strength of 3300 kg/cm², for example.

When a tape-like base material of ceramics is employed, the superconductive elongated body after formation of the superconductive layer is preferably not more than 500 »m, and more preferably, not more than 55 »m in thickness.

When a base material of ceramics in the form of a round wire is employed, on the other hand, the superconductive elongated body after formation of the superconductive layer is preferably not more than 500 »m, and more preferably, not more than 55 »m in diameter.

When a superconductivity stabilizing material is employed as the base material, a thin film of an oxide superconductive material formed on the surface thereof provides a superconductor showing a high critical temperature. As the result, the conductor coated with the superconductive material thus obtained shows a stable superconductive state through function of the superconductivity stabilizing material. Such superconductivity stabilizing material is preferably prepared by Cu, Al etc. According to the inventive method, further, a layer of a superconductivity stabilizing material and a layer of an oxide superconductive material may be alternately formed to provide a conductor coated with a superconductive material being in multilayer structure. When the superconductivity stabilizing material is prepared by an elongated one, obtained is a conductor coated with a superconductive material in the form of a wire material such as a round wire having a circular sectional configuration of multilayer structure or a rectangular wire having a different sectional configuration. Thus, the present invention is widely applicable in the field of superconductive wires etc.

The inventive method requires no specific equipments such as a heating apparatus for the base material and the film materials as compared with the vapor phase method, and can be performed under a low temperature. Further, cleanliness is not strictly required on the surface to be provided with a film, while no polishing in a high degree is required as pretreatment for the surface.

According to the inventive manufacturing method, the superconductive layer is formed on at least a part of the surface of a flexible base material, thereby to obtain a highly practical superconductive elongated body having flexibility, which can be wound up by a reel.

According to the present invention, further, interconnection resistance can be easily reduced through characteristics of the superconductive material, whereby the operating speed of an electronic device such as an IC or an LSI can be increased beyond the limit with increase in speed of semiconductor devices.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a process drawing schematically showing a method of manufacturing an oxide superconductive material according to the present invention;
Fig. 4A is a schematic structural diagram conceptually showing an apparatus for forming a superconductive layer on the surface of an elongated base material, for illustrating an Example of the present invention; and
Figs. 4B and 4C are sectional views showing superconductive elongated bodies obtained through the apparatus as shown in Fig. 4A.

### DESCRIPTION OF THE PREFERRED EMBODIMENTS

In general, steps of manufacturing an oxide superconductive material according to the present invention are as follows:

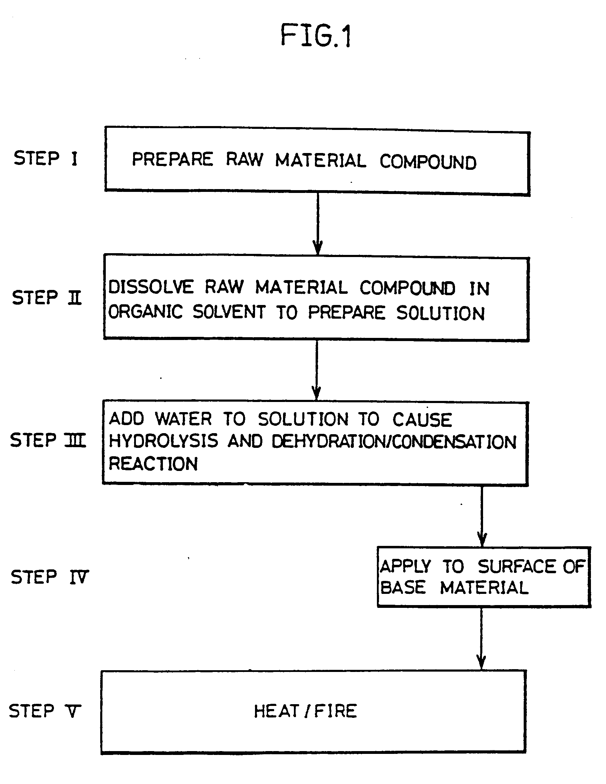

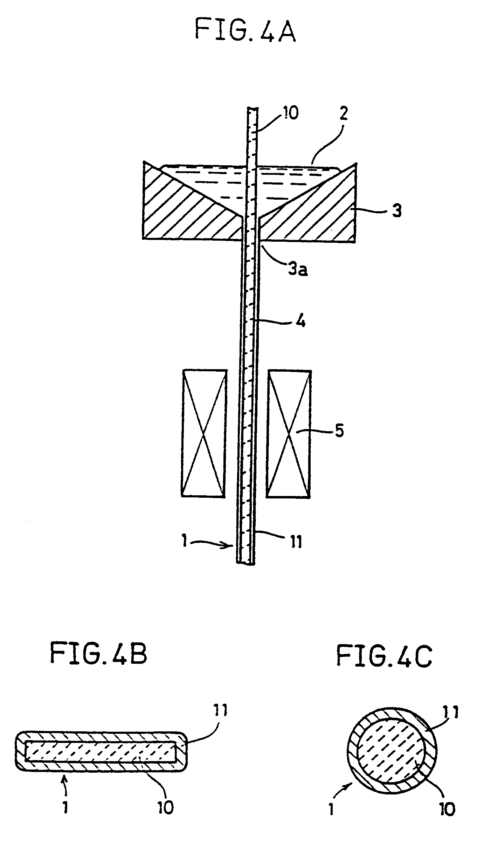

Referring to Fig. 1, raw material compounds are first prepared by alkoxides, carboxylates or acetylacetonates of respective metal elements for composing an oxide superconductive material. Then the raw material compounds are dissolved in an organic solvent, to prepare a solution. Then water is added to this solution, to cause hydrolysis and dehydration/condensation reaction. Thereafter the solution caused to solate or gelate by such reaction is heated to obtain an oxide superconductive material. A thin film of the oxide superconductive material is formed on the surface of a base material by applying the solating or gelating solution on the surface of the base material and heating/firing the same.

The steps of manufacturing the oxide superconductive material as schematically shown in Fig. 1 are now described with reference to Examples.

In the following the Examples 1, 2, 5, 6 which are not within the scope of the claim are provided for technical in formation only.

### Example 1

An isopropanol solution was prepared by adding 1 mole of yttrium-tri-3-ethyl-pentoxide: 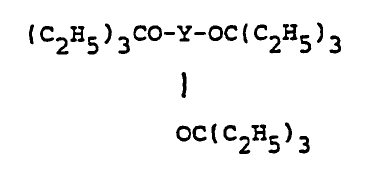
2 moles of barium-tri-3-ethyl-pentoxide: 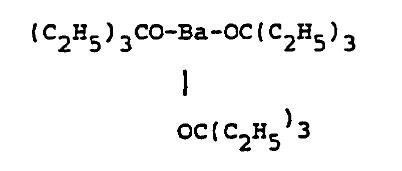
and 3 moles of copper-tri-3-ethyl-3-pentoxide: 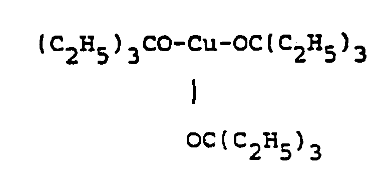
as a solution containing alkoxides of respective metal elements for composing an oxide superconductive material. Further, a small amount of acetylacetone was added to the substance to stir/mix the same while performing reflux at the room temperature. Thereafter water diluted by alcohol to 1 percent by weight in concentration was added to the mixed solution to cause hydrolysis. The amount of water added to each alkoxide was in correspondence to 0.2 equivalent in mole ratio. Thereafter the substance was stirred at a temperature of 40°C for four hours, and stood to be cooled to the room temperature.

A sol solution thus obtained was left until its viscosity reached 20 poises.

This sol solution was employed to manufacture a superconductive ceramics elongated body in accordance with the inventive method through an apparatus as shown in Fig. 4A.

Fig. 4A is a schematic structural diagram showing an apparatus for illustrating this Example of the present invention. The apparatus as shown in Fig. 4A is formed by a crucible 3 for receiving a sol solution 2 and a heating furnace 5. A hole 3a is defined in a central portion of the crucible 3, to pass a ceramics elongated base material 10.

The sol solution 2 prepared in the aforementioned manner was introduced into the crucible 3. A ceramics elongated base material 10, being prepared by a zirconia tape of 50 »m in thickness and 3 mm in width, was introduced into the crucible 3 from above to be passed through the sol solution, which was kept at a temperature of 40°C, at a speed of 2.0 cm/min., and drawn out through the hole 3a of the crucible 3. The ceramics elongated base material 10 thus drawn out from the hole 3a of the crucible 3 was provided on its surface with a gelating film 4 formed by the sol solution. The gelating film 4 was about 15 »m in thickness.

The ceramics elongated base material 10 provided with the gelating film 4 was then introduced into the heating furnace 5 located in a lower position, to be heated to 800°C. Then the ceramics elongated base material 10 was downwardly drawn out from the heating furnace 5, to provide a superconductive elongated body 1 formed on its surface with a superconductive layer 11 of Y-Ba-Cu-O oxide, being in the form of a tape-like linear body.

Such application and firing were repeated several times, to obtain the superconductive elongated body 1 provided with the superconductive layer 11 of about 5 »m in thickness.

As the result of analysis of the superconductive layer of the superconductive elongated body thus obtained through an X-ray diffraction method, it has been proved that the superconductive layer was in layer perovskite structure, which is typical crystal structure of a high-temperature superconductive oxide. This superconductive elongated body presented a superconductive state at a temperature in excess of the boiling point of 77 K of liquid nitrogen.

Even if the superconductive elongated body was bent to 30 cm in radius of curvature, no damage was caused on the ceramics elongated body with no cracking in the superconductive layer, while superconductivity thereof was not damaged.

Fig. 4B is a sectional view showing the tape-like superconductive elongated body 1 thus obtained. The superconductive layer 11 is formed on the outer peripheral surface of the tape-like ceramics elongated base material 10. Although the tape-like superconductive elongated body 1 was manufactured in this Example, a superconductive elongated body 1, which is formed with a superconductive layer 11 on the surface of a ceramics elongated base material 10 being in the form of a round wire, may be manufactured as shown in Fig. 4C.

### Example 2

A sol solution was prepared in a similar manner to Example 1 A zirconia tape similar to that in Example 1 was dipped in the sol solution as a tape-like ceramics elongated base material, to form a coating layer of about 15 »m in thickness. The ceramics elongated base material was taken out from the solution and heated to 800°C, to form a superconductive layer of Y-Ba-Cu-O oxide on its surface. Such dipping and heating were repeated several times, to finally obtain a superconductive ceramics elongated body provided with a superconductive layer of 5 »m in thickness.

The superconductive ceramics elongated body thus obtained presented a superconductive state at a temperature in excess of the boiling point of 77 K of liquid nitrogen, while no cracking or disconnection was caused even if the same was bent to about 30 cm in radius of curvature.

### Example 3

Yttrium-3-ethyl-3-pentoxide and barium-3-ethyl-3-pentoxide were prepared as alkoxides of yttrium and barium, being metal elements for composing an oxide superconductive material. Copper-2-ethylhexanoate, being a carboxylate of copper, was added to these alkoxides, to prepare a raw material compound. The mixing mole ratio of the raw material compound was yttrium-3-ethyl-pentoxide : barium-3-ethyl-3-pentoxide : copper-2-ethylhexanoate = 1:2:3. A solvent prepared by mixing t-heptanol and p-xylene in the ratio of 1:5 was added to the raw material compound, to prepare a solution containing the raw material compound.

The solution was stirred for 15 minutes in a constant humidity/constant temperature bath of 30°C in temperature and 20 % in relative humidity, to cause hydrolysis and dehydration/condensation reaction. Concentration of the raw material compound with respect to the solution was 18.5 wt.%.

A sol solution thus obtained was left until its kinematic viscosity reached 20 cSt.

Thereafter a substrate of polycrystal YSZ (yttria stabilized zirconia) of 30 mm x 30 mm x 0.5 mm was dipped in the sol solution through the dipping method and then raised up at a speed of 1.3 cm/min., to perform coating in the atmosphere. The coated substrate was fired in the atmosphere at a temperature of 850°C for one hour, and then annealed to the room temperature at a cooling speed of 1°C/min. Thereafter the substrate was further fired in an oxygen atmosphere of 1 atm at a temperature of 700°C for one hour, to be then annealed to the room temperature at a cooling speed of 1°C/min.

Thus, a superconductive layer of Y-Ba-Cu-O oxide was formed on the surface of the substrate. Thickness of the superconductive layer was about 0.5 to 1.0 »m. The critical temperature of this superconductive layer was measured by the four-terminal resistance method, to confirm that reduction in electric resistance started at a temperature of 87 K and a superconductive state was attained at a temperature of 50 K, to form a superconductor presenting a high critical temperature.

### Example 4

Yttrium-3-ethyl-3-pentoxide and barium-3-ethyl-3-pentoxide were prepared as alkoxides of yttrium and barium, being metal compounds for composing an oxide superconductive material. Copper-2-ethylhexanoate, being a carboxylate of copper, was added to these alkoxides to prepare a raw material compound. The mixing mole ratio of this raw material compound was yttrium-3-ethyl-pentoxide : barium-3-ethyl-3-pentoxide : copper-2-ethylhexanoate = 1:2:3. A solvent prepared by mixing t-heptanol and p-xylene in the ratio of 1:5 was added to the raw material compound, to prepare a solution containing the raw material compound.

The solution thus obtained was stirred for 30 minutes in a constant humidity/constant temperature bath of 30°C in temperature and 20 % in relative humidity, to cause hydrolysis and dehydration/condensation reaction. Concentration of the raw material compound with respect to the solution was 18.5 wt.%.

The sol solution thus obtained was left until its kinematic viscosity reached 50 cSt.

Then the sol solution was dripped on a substrate of polycrystal YSZ (yttria stabilized zirconia) of 50 mm x 50 mm x 0.5 mm while rotating the same at 500 r.p.m. by a spin coating method, to perform coating in the atmosphere. The coated substrate was fired in the atmosphere at a temperature of 850°C for one hour, and then annealed to the room temperature at a cooling speed of 1°C/min. Thereafter the substrate was further fired in an oxygen atmosphere of 1 atm at a temperature of 700°C for two hours, and then annealed to the room temperature at a cooling speed of 1°C/min.

Thus, a superconductive layer of Y-Ba-Cu-O oxide was formed on the surface of the substrate. Thickness of the superconductive layer was about 0.5 to 1.0 »m. The critical temperature of this superconductive layer was measured by the four-terminal resistance method, to confirm that reduction in electric resistance started at a temperature of 85 K and a superconductive state was attained at a temperature of 68 K, to provide a superconductor presenting a high critical temperature.

### Example 5

Yttrium-2-ethylhexanoate, barium-2-ethylhexanoate and copper-2-ethylhexanoate for yttrium, barium and copper were mixed as carboxylates of metal elements for composing an oxide superconductive material to prepare a raw material compound. The raw material compound was in mixing mole ratio of yttrium-2-ethylhexanoate : barium-2-ethylhexanoate : copper-2-ethylhexanoate = 1:2:3. Octanol was added to the raw material compound as a solvent, to prepare a solution containing the raw material compound.

0.2 mole of water was added to the solution, which was then stirred at a temperature of 90°C for three hours, to cause hydrolysis and dehydration/condensation reaction. Concentration of the raw material compound with respect to the solution was 9.3 wt.%.

The sol solution thus obtained was left until its kinematic viscosity reached 35 cSt.

Thereafter a substrate of polycrystal YSZ (yttria stabilized zirconia) of 30 mm x 30 mm x 0.5 mm was dipped in the sol solution by the dipping method and then raised up at a speed of 1.3 cm/min., to perform coating in the atmosphere. The coated substrate was fired in the atmosphere at a temperature of 500°C for one hour, and then annealed to the room temperature at a cooling speed of 1°C/min. Thereafter the substrate was further fired in an oxygen atmosphere of 1 atm at a temperature of 800°C for three hours, and then annealed to the room temperature at a cooling speed of 1°C/min.

Thus, a superconductive layer of Y-Ba-Cu-O oxide was formed on the surface of the substrate. Film thickness of the superconductive layer was about 0.5 to 1.0 »m. The critical temperature of this superconductive layer was measured through the four-terminal resistance method, to confirm that reduction in electric resistance started at a temperature of 65 K and a superconductive state was attained at a temperature of 30 K, to provide a superconductor having a high critical temperature.

### Example 6

Yttrium-3-ethyl-3-pentoxide, barium-3-ethyl-3-pentoxide and copper-2-ethylhexanoate were prepared for yttrium, barium and copper respectively as compounds of respective metal elements for composing an oxide superconductive material, and each compound was independently dissolved in 300 ml of a mixed solvent of paraxylene : n-butanol = 1:1, to be 10 wt.% in concentration. Then water diluted to 3 % by butanol was added to only the solution of barium-3-ethyl-3-pentoxide in 1 equivalent with respect to barium at the room temperature and stirred for one hour, to cause hydrolysis and dehydration/condensation reaction. The solutions of yttrium-3-ethyl-3-pentoxide and copper-2-ethylhexanoate were respectively stirred in a constant temperature/constant humidity bath of 30°C in temperature and 20 % in relative humidity to cause hydrolysis and dehydration/condensation reaction, and thereafter softly mixed with each other. The hydrolyzed solution of barium-3-ethyl-3-pentoxide was dripped in the mixed solution at a speed of about 5 cc/min. After such dripping, the solution, in which particulate substances were observed, was heated at 50°C for 10 minutes to obtain a completely transparent viscous solution. Relative viscosity of this solution was 54 cSt at the room temperature. Then the sol solution was dripped on a substrate of polycrystal YSZ (yttria stabilized zirconia) of 50 mm x 50 mm x 0.5 mm through the spin coating method while rotating the substrate at 500 r.p.m., to perform coating in the atmosphere. The coated substrate was fired in the atmosphere at a temperature of 850°C for one hour, and then annealed to the room temperature at a cooling speed of 1°C/min. Thus, a superconductive layer of Y-Ba-Cu-O oxide was formed on the surface of the substrate. This superconductive layer was 1.8 to 3.2 »m in thickness. The critical temperature of the superconductive layer was measured by the four terminal method, to find that reduction in resistance started at a temperature of 84 K, and a complete superconductive state was attained at a temperature of 65 K.

## Claims

1. A method of forming a superconductive layer of Y-Ba-Cu-O on the surface of a substrate of polycrystal yttria stabilized zirconia, characterized in
preparing yttrium-3-ethyl-3-pentoxide and barium-3-ethyl-3-pentoxide and mixing them with copper-2-ethyl-hexanoate to provide a raw material compound,
dissolving said raw material compound in a mixture of 1 part (vol) t-heptanol and 5 parts (vol) p-xylene
adding water to said solution and causing a hydrolysis and dehydration/condensation reaction
coating said solution on a substrate of polycrystal yttria stabilized zirconia;
and firing the coated film formed on said substrate.

## Patentansprüche

1. Verfahren zur Bildung einer supraleitenden Schicht aus Y-Ba-Cu-O auf der Oberfläche eines Substrats aus polykristallinem, mit Yttriumoxid stabilisierten Zirconiumdioxid, dadurch gekennzeichnet, daß
man Yttrium-3-ethyl-3-pentoxid und Barium-3-ethyl-3-pentoxid herstellt und sie mit Kupfer-2-ethyl-hexanoat mischt und so eine Rohmaterialverbindung erzeugt;
die Rohmaterialverbindung in einem Gemisch aus 1 Teil (vol) t-Heptanol und 5 Teilen (vol) p-Xylol löst,
Wasser zu der Lösung gibt und eine Hydrolyse und Dehydrierungs-/Kondensationsreaktion bwirkt,
die Lösung auf einen Substrat aus polykristallinem, mit Yttriumoxid stabilisiertem Zirconiumioxid aufträgt, und
den schichtförmigen Film, der auf dem Substrat gebildet ist, brennt.

## Revendications

1. Procédé de production d'une couche supraconductrice à base de Y-Ba-Cu-O à la surface d'un substrat polycristallin d'oxyde de zirconium stabilisé par de l'oxyde d'yttrium, caractérisé en ce que
l'on prépare du 3-éthyl-3-pentoxyde d'yttrium et du 3-éthyl-3-pentoxyde de baryum auxquels on mélange du 2-éthyl-hexanoate de cuivre pour obtenir un mélange de matières brutes,
on dissout ledit mélange de matières brutes dans un mélange formé de 1 partie en volume de t-heptanol et de 5 parties en volume de p-xylène,
on ajoute de l'eau à ladite solution pour induire une réaction d'hydrolyse et de déshydratation/condensation,
on enduit ladite solution sur un substrat polycristallin d'oxyde de zirconium stabilisé par de l'oxyde d'yttrium, et
on flambe ledit film de revêtement formé sur ledit substrat.
